# FASCICULE DE BREVET EUROPEEN

(11) **EP 2 807 734 B1**
(45) Date de publication et mention de la délivrance du brevet: **09.05.2018**
(21) Numéro de dépôt: 13701619.2
(22) Date de dépôt: 24.01.2013
(51) Int. Cl.: H02K 11/02, H01F 17/04, H01F 27/255, H03H 7/42

(54) **FILTRE ATTÉNUATEUR/ÉLIMINATEUR DE BANDE DES INDUCTIONS ÉLECTROMAGNÉTIQUES POUR MOTEUR À COURANT CONTINU À BALAIS**
BANDDÄMPFUNGS-/ELIMINATIONSFILTER FÜR DIE ELEKTROMAGNETISCHEN EMISSIONEN EINES GLEICHSTROMMOTORS MIT BÜRSTEN
BAND ATTENUATION/ELIMINATION FILTER FOR THE ELECTROMAGNETIC EMISSIONS OF A DC MOTOR WITH BRUSHES

(30) Priorité: 24.01.2012 FR 1250664
(43) Date de publication de la demande: 03.12.2014
(73) Titulaire: Valeo Systèmes d'Essuyage, 78322 Le Mesnil Saint Denis (FR)
(72) Inventeur: BLANCHET, Pierre, 86140 Clairvaux (FR); PILARD, Pierre, 86220 Saint Remy Sur Creuse (FR); SERVIN, Alain, 86190 Villiers (FR)
(74) Mandataire: Callu Danseux, Violaine
(86) Numéro de dépôt international: PCT/EP2013/051372
(87) Numéro de publication internationale: WO 2013/110726

(56) Documents cités:
- EP-A2- 0 336 530
- EP-A2- 1 282 143
- JP-A- 4 094 586
- JP-A- 2003 068 534
- JP-A- 2003 332 136
- JP-U- 55 067 668
- JP-Y1- S 496 242
- US-A- 5 914 644

## Description

L'invention concerne un filtre atténuateur/éliminateur de bande des inductions électromagnétiques pour moteur à courant continu à balais.

Les moteurs à courant continu utilisés pour l'équipement des véhicules automobiles, notamment les moteurs d'essuie-glaces, comportent un collecteur tournant sur les secteurs duquel des balais en contact avec ces secteurs permettent l'alimentation de l'induit et l'entraînement du moteur.

Au cours du fonctionnement de ce type de moteur, le contact des balais sur les secteurs discrets successifs du collecteur provoque des phénomènes transitoires de commutation, lors de la commutation du contact électrique successif des balais avec les secteurs discrets du collecteur tournant.

Ces phénomènes transitoires sont générateurs de parasites et/ou d'interférences, lesquels peuvent être analysés en des impulsions à structure fréquentielle harmonique erratique, à très haute fréquence, pouvant être comprise entre 100 MHz et 1GHz, mais de niveau d'amplitude élevée, en particulier lors de la commutation du contact des balais sur les secteurs successifs du collecteur.

Ces parasites et/ou interférences se propagent sans grande difficulté sur les lignes d'alimentation et/ou de transmission de signaux du véhicule automobile.

En cela, ils apparaissent préjudiciables non seulement au confort des utilisateurs du véhicule, lorsque ces parasites et/ou interférences se propagent, par exemple, sur les circuits audio d'un récepteur radiofréquence du véhicule, mais également au bon fonctionnement, voire à la sécurité, du véhicule, lorsque ces derniers se propagent sur les lignes de commande, de contrôle ou de régulation des organes du véhicule, tels que notamment les organes de contrôle de vitesse et/ou de freinage.

Ces parasites et/ou interférences sont en outre préjudiciables au bon fonctionnement des circuits mémoire et de calcul embarqués équipant les véhicules automobiles actuels.

Parmi les solutions de l'art antérieur utilisées pour réduire le niveau d'amplitude de ces parasites et/ou interférences, on peut citer les filtres EMC, pour Electronic Magnetic Compatibility en anglais, lesquels comportent, habituellement, un système de filtre à inductances intercalées entre les bornes de connexion du moteur et les bornes d'alimentation de la batterie comme illustré dans la publication JP Q49 6242 Y1.

Compte tenu des valeurs d'inductances normalement utilisées, ce type de filtre permet d'obtenir une atténuation convenable des parasites et/ou des interférences pour des fréquences dont les composantes harmoniques sont inférieures à 100 MHz environ.

D'autres solutions ont été proposées pour tenter de réduire ou supprimer les parasites et/ou interférences engendrés par le contact des balais sur les secteurs du collecteur dans un moteur à courant continu.

Parmi celles-ci, on a proposé des circuits du type filtre capacitif auxquels sont ajoutées une ou plusieurs diodes. Les diodes introduites ont pour objet d'effectuer essentiellement un écrêtage des impulsions ou pics des signaux parasites et/ou interférences. Une telle solution est par exemple décrite par le brevet US 3 732 285.

Une autre solution, telle que décrite par la demande EP 336 530, consiste par exemple à prévoir un filtrage en bande HF par un circuit HF et un filtrage en bande BF par un circuit BF.

Cette solution apparaît complexe à mettre en oeuvre et implique la construction et l'implantation de circuits multiples.

La présente invention à pour objet de remédier aux inconvénients des solutions de filtrage des inductions électromagnétiques des moteurs à courant continu de l'art antérieur par la mise en oeuvre d'une structure de filtrage à bande unique dans une plage de fréquences comprises entre 100 MHz et 1 GHz.

Un autre objet de la présente invention est en outre la mise en oeuvre d'un filtre atténuateur/éliminateur de bande des inductions électromagnétiques pour moteur à courant continu à balais totalement compatible avec les filtres EMC actuels et pouvant, en conséquence, être intégré dans ces derniers, ou partiellement ajoutés à ces derniers, sans toutefois introduire une augmentation du volume et de l'encombrement du moteur.

Le filtre atténuateur/éliminateur de bande des inductions électromagnétiques pour moteur à courant continu à balais, objet de l'invention est conforme à la revendication 1. Il est plus particulièrement destiné aux moteurs d'essuie-glaces.

Il est remarquable en ce qu'il comporte au moins, intégrées à un filtre à inductances de compatibilité électromagnétique formé par au moins une première impédance réactive insérée entre la borne d'alimentation positive moteur et la borne positive de la batterie et une deuxième impédance réactive insérée entre la borne d'alimentation négative moteur et la masse du véhicule, une première impédance capacitive connectée en parallèle entre la borne positive et la borne négative d'alimentation moteur, et, une deuxième impédance capacitive de capacité électrique inférieure à celle de la première impédance capacitive et connectée en parallèle entre la borne positive de la batterie et la borne de masse du moteur.

Le filtre atténuateur/éliminateur de bande des inductions électromagnétiques pour moteur à courant continu à balais, objet de l'invention, est en outre remarquable en ce que la deuxième impédance capacitive est constituée par des capacités électriques connectées en série, le point milieu des deux capacités électriques étant connecté à la carcasse métallique du moteur.

Le filtre atténuateur/éliminateur de bande des inductions électromagnétiques pour moteur à courant continu à balais objet de l'invention, est également remarquable en ce que la première, la deuxième et la troisième capacité électrique ont une même valeur, inférieure à 1µF.

Le filtre atténuateur/éliminateur de bande des inductions électromagnétiques pour moteur à courant continu à balais, objet de l'invention, est en outre remarquable en ce qu'il comporte en outre au moins une troisième impédance réactive insérée en série entre la borne d'entrée de la première impédance réactive et la borne positive de la batterie, et, entre la borne de sortie de la deuxième impédance réactive et la borne de masse du véhicule.

Le filtre atténuateur de bande des inductions électromagnétiques pour moteur à courant continu à balais, objet de l'invention, est en outre remarquable en ce qu'il comprend une quatrième impédance réactive insérée en série sur un circuit d'alimentation auxiliaire du moteur.

Le filtre atténuateur de bande des inductions électromagnétiques pour moteur à courant continu à balais, objet de l'invention, est également remarquable en ce que la troisième et la quatrième impédance réactive ont une impédance de valeur identique, supérieure à 50 ohms dans une bande de fréquences comprises entre 100 MHz et 1GHz.

Le filtre atténuateur/éliminateur de bande des inductions électromagnétiques pour moteur à courant continu à balais, objet de l'invention, est également remarquable en ce que la troisième et la quatrième impédance réactive sont constituées chacune par une inductance à noyau de ferrite. Des inductances à noyau de ferrite sont par exemple décrites dans le document JP2003-68534A.

Le filtre atténuateur/éliminateur de bande des inductions électromagnétiques pour moteur à courant continu à balais, objet de l'invention, est également remarquable en ce que les self inductances à noyau de ferrite sont placées sur la plaque de fermeture du moteur de façon à entourer chaque piste conductrice d'alimentation reliée à la borne d'alimentation batterie respectivement à la borne de masse du véhicule ou aux circuits d'alimentation auxiliaire du moteur.

Le filtre atténuateur/éliminateur de bande des inductions électromagnétiques pour moteur à courant continu à balais, objet de l'invention, est en outre remarquable en ce que les self inductances à noyau de ferrite sont formées chacune par un premier élément de noyau de ferrite présentant un logement longitudinal central, et, par un deuxième élément de noyau de ferrite présentant un logement longitudinal central, identique à celui du premier élément de noyau ferrite, le premier et le deuxième élément de noyau de ferrite étant placés en vis-à-vis de façon à former, au niveau de leur logement longitudinal central en vis-à-vis, un manchon de passage entourant l'une au moins des pistes conductrices d'alimentation.

Le filtre atténuateur/éliminateur de bande des inductions électromagnétiques pour moteur à courant continu à balais, objet de l'invention, est enfin remarquable en ce que les self inductances à noyau de ferrite entourant chaque piste conductrice d'alimentation et chacune des pistes conductrices d'alimentation ou d'alimentation auxiliaire sont placées sur la plaque de fermeture du moteur, le premier et le deuxième élément de noyau de ferrite formant chaque inductance à noyau de ferrite étant maintenus chacun en vis-à-vis par un doigt à cliquet venu de matière de la plaque de fermeture.

La présente description décrit également une impédance réactive à noyau de ferrite pour filtrage des inductions électromagnétiques pour moteur à courant continu à balais. Cette impédance réactive est remarquable en ce qu'elle est formée par un premier élément de noyau de ferrite présentant un logement longitudinal central, et, par un deuxième élément de noyau de ferrite présentant un logement longitudinal central, identique à celui du premier élément de noyau ferrite. Le premier et le deuxième élément de noyau de ferrite sont placés en vis-à-vis de façon à former, au niveau de leur logement longitudinal central en vis-à-vis, un manchon de passage entourant l'une au moins des pistes conductrices d'alimentation.

L'impédance réactive objet de l'invention est en outre remarquable en ce que cette impédance est placée de façon à entourer au moins une piste d'alimentation principale ou auxiliaire du moteur.

Le filtre atténuateur/éliminateur de bande des inductions électromagnétiques pour moteur à courant continu à balais, objet de l'invention, trouve application à l'équipement d'essuie-glaces de véhicules automobiles de tout type.

Il sera mieux compris à la lecture de la description et à l'observation des dessins ci-après dans lesquels :
- la figure 1 représente, à titre illustratif, le schéma électrique d'un filtre atténuateur/éliminateur de bande des inductions électromagnétiques pour moteur à courant continu à balais, connu de l'art antérieur ;
- la figure 2 représente un mode de mise en oeuvre préférentiel non limitatif du filtre atténuateur/éliminateur de bande des inductions électromagnétiques objet de l'invention,;
- la figure 3a représente une vue de dessus de l'implantation d'éléments spécifiques du filtre atténuateur/éliminateur de bande des inductions électromagnétiques, objet de l'invention tel que représenté en figure 2 ;
- la figure 3b représente, à titre illustratif, selon un plan de coupe PP de la figure 3a , représenté par sa trace dans le plan de cette figure, une étape de montage des éléments spécifiques représentés en figures 3a, ces éléments spécifiques étant constitués par des impédances réactives à noyau de ferrite plus spécialement adaptées à la réalisation industrielle du filtre objet de la présente invention ;
- la figure 3c représente, selon la vue en coupe précitée, les éléments spécifiques constitués par des impédances réactives placées sur la plaque de fermeture du moteur à balais considéré ;
- la figure 4 représente le schéma électrique d'un filtre objet de l'invention dans lequel une impédance réactive est placée sur un circuit auxiliaire d'alimentation, outre le circuit principal d'alimentation moteur ; et
- la figure 5 représente une vue en perspective d'un circuit de prise de masse pour connexion de balai d'un moteur à courant continu représentant l'implantation d'éléments spécifiques du filtre atténuateur/éliminateur de bande des inductions électromagnétiques, objet de l'invention, dans le moteur.

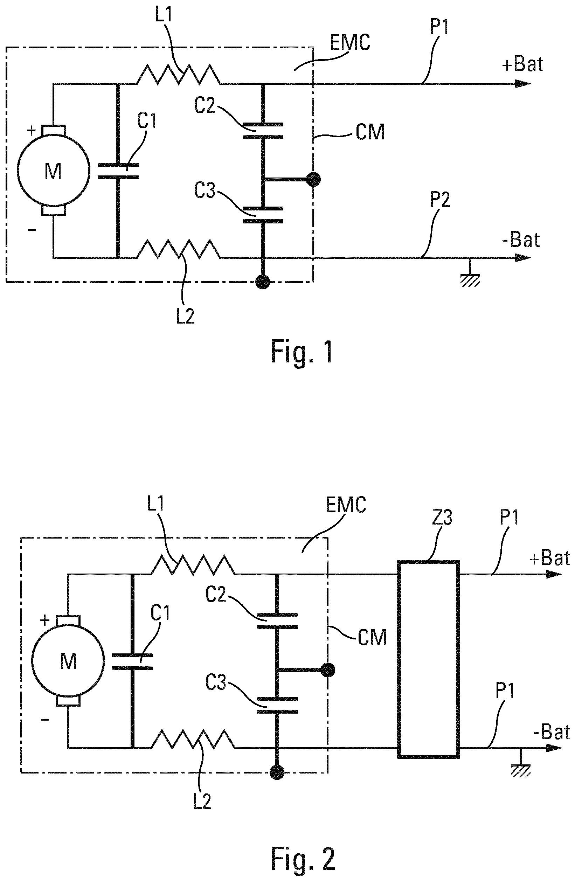

Une description plus détaillée du filtre atténuateur/éliminateur de bande des inductions électromagnétiques pour moteur M à courant continu à balais, objet de l'invention, sera maintenant donnée en liaison avec la figure 2 et les figures suivantes.

En référence à la figure 1, on observe qu'un filtre de l'art antérieur comporte par exemple, intégrées à un filtre à inductances de compatibilité électromagnétique, noté EMC, formé par au moins une première impédance réactive L1 insérée entre la borne d'alimentation positive moteur et la borne positive de la batterie +Bat et par une deuxième impédance réactive L2 insérée entre la borne d'alimentation négative moteur et la masse du véhicule, notée - Bat, une première impédance électrique capacitive, C1, connectée en parallèle entre la borne positive et la borne négative d'alimentation moteur et une deuxième impédance électrique capacitive, notée C2,C3, présentant une capacité électrique inférieure à celle de la première impédance capacitive C1 et connectée en parallèle entre la borne positive de la batterie +Bat et la borne de masse du moteur. Par convention, la borne de masse du moteur M est notée sur la figure 1 et sur les figures suivantes par un point noir de connexion à la carcasse métallique du moteur CM. On note que la borne de masse du moteur, c'est-à-dire la carcasse métallique CM de ce dernier, peut être avantageusement connectée à la masse du véhicule -Bat.

D'une manière plus spécifique, on indique que la deuxième impédance capacitive C2,C3 est constituée par des capacités électriques C2 respectivement C3 connectées en série, le point milieu des deux capacités électriques étant connecté à la carcasse métallique CM du moteur M.

De manière avantageuse, selon une mise en oeuvre de l'invention, la première C1, la deuxième C2 et la troisième C3 capacité électrique ont une même valeur de capacité électrique, inférieure à 1µF.

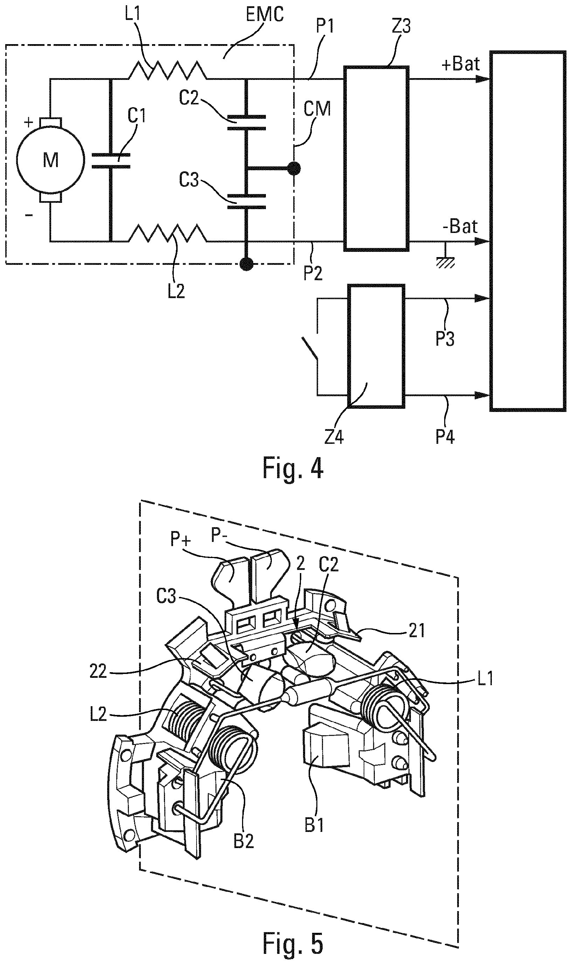

De préférence, le filtre atténuateur/éliminateur de bande des inductions électromagnétiques, objet de l'invention, est implanté dans le moteur M. La figure 5 représente un exemple d'implantation non limitatif de ce filtre, les impédances réactives L1, L2 et les impédances électriques capacitives C2, C3, appartiennent dans cet exemple à un circuit de prise de masse pour connexion de balai de moteur à courant continu.

Dans l'exemple de réalisation de la figure 5, le circuit de prise de masse comprend des charbons ou balais B1, B2, chaque charbon B1, B2 est connecté par une lame souple et une impédance réactive L1, L2 à un plot de connexion P+, P- à la borne positive respectivement à la borne négative d'alimentation par la batterie du véhicule.

De plus, le circuit de prise de masse comprend au moins une plaquette métallique 2 présentant à chacune de ses extrémités une zone de contact électrique 21 respectivement 22. Chaque zone de contact électrique est destinée à être placée en contact électrique avec l'inducteur du moteur, connecté à la masse du moteur, par l'intermédiaire du carter métallique du moteur.

Les impédances électriques capacitives C2, C3 comportent une première branche électriquement connectée à la plaquette métallique 2 et une deuxième branche électriquement connectée au plot de connexion P+ à la borne positive respectivement au plot de connexion P- à la borne négative d'alimentation par la batterie.

De préférence, les impédances électriques capacitives C2 et C3 ont une branche commune reliée directement à la plaquette métallique 2, leur autre branche respective étant connectée directement à l'impédance réactive L1 qui est connectée au charbon B1 et au plot de connexion P- respectivement à l'impédance réactive L2 qui est connectée au charbon B2 et au plot de connexion P+.

Le filtre objet de l'invention, tel que défini en référence à la figure 1, permet d'obtenir une atténuation/élimination de bande des inductions électromagnétiques pour moteur à courant continu à balais comprise entre 5 et 10 dB sur la bande de fréquences comprises entre 100 MHz et 1GHz, en comparaison des filtres EMC classiques.

Une variante de mise en oeuvre préférentielle non limitative du filtre objet de l'invention est maintenant décrite en liaison avec la figure 2.

Alors que la première et la deuxième impédance capacitive sont directement intégrées au filtre à inductance capacité de compatibilité électromagnétique EMC, dans un mode de réalisation préférentiel, le filtre atténuateur/éliminateur de bande des inductions électromagnétiques pour moteur à courant continu à balais, objet de l'invention, comporte en outre au moins une troisième impédance réactive Z3, connectée en série entre la borne d'entrée de la première impédance réactive L1 et la borne positive de la batterie +Bat et entre la borne de sortie de la deuxième impédance réactive L2 et la borne de masse du véhicule.

On comprend que, par convention, la borne d'entrée de la première impédance réactive L1 et la borne de sortie de la deuxième impédance réactive L2 font référence au sens de circulation du courant continu d'alimentation délivré par les bornes +Bat, -Bat de la batterie, mais que la troisième impédance réactive précitée introduit une atténuation sélective sur les circuits externes d'alimentation pour les signaux parasite engendrés par la commutation des balais du moteur vers les circuits externes de la batterie et du véhicule.

De préférence, la troisième impédance réactive Z3 peut être constituée par une impédance à noyau de ferrite unique entourant les pistes principales P1, P2 d'alimentation moteur. Des impédances Z3 séparées sur chaque piste d'alimentation moteur P1, P2 peuvent en outre être mises en oeuvre

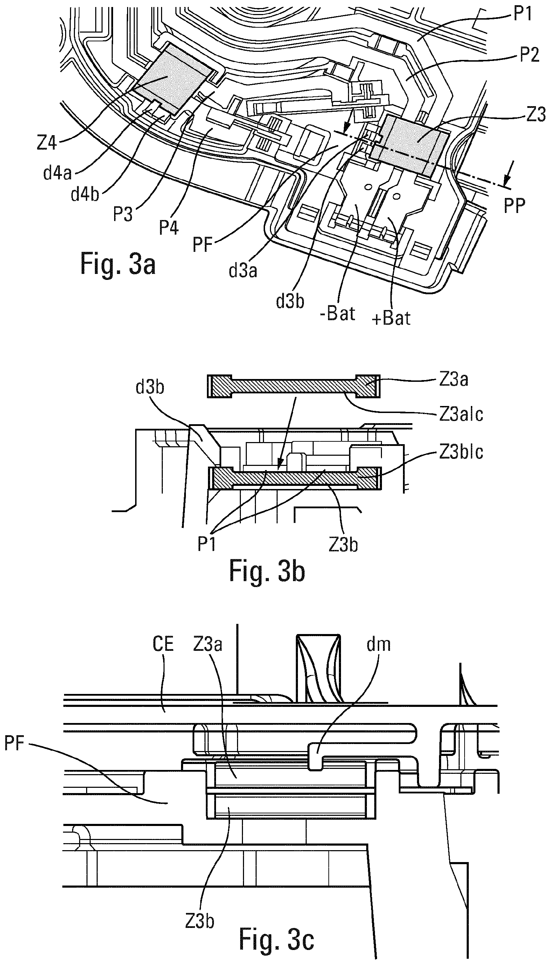

En outre, lorsque le moteur comporte des pistes d'alimentation auxiliaire, ces pistes auxiliaires alimentant une ou plusieurs fonctions auxiliaires par exemple, le filtre objet de l'invention peut comprendre avantageusement au moins une autre impédance réactive insérée en série sur le circuit d'alimentation auxiliaire précité. Une telle impédance réactive est désignée quatrième impédance réactive et référencée Z4 sur la figure 3a.

De préférence, la troisième Z3 et la quatrième Z4 impédance réactive ont une impédance de valeur identique, supérieur à 50 ohms, dans la bande d'atténuation de fréquences comprises entre 100 M H z et 1GH z .

Dans cette configuration, le filtre objet de l'invention, permet l'obtention d'une atténuation/élimination de bande des inductions électromagnétiques comprise entre 15 dB et 20 dB, sur la bande de fréquences comprise entre 100 MHz et 1 GHz, en comparaison des filtres EMC classiques.

Dans un mode de réalisation préférentiel, la troisième Z3 et la quatrième Z4 impédance réactive sont constituées chacune par une inductance à noyau de ferrite.

Sur la figure 3a , on a représenté l'agencement de la troisième Z3 et de la quatrième Z4 impédance réactive, constituées par les selfs inductances précitées à noyau de ferrite, placées sur la plaque de fermeture PF du moteur M. La figure 3a représente une vue de dessus du moteur M et des circuits électriques de ce dernier placés sur la plaque de fermeture PF, le capot d'étanchéité CE de l'ensemble moteur étant supprimé.

Ainsi qu'il apparaît à l'observation de la figure 3a, les self inductances Z3 et Z4 sont placées sur la plaque de fermeture PF de façon à entourer chaque piste conductrice d'alimentation moteur, P1, P2,respectivement les pistes d'alimentation auxiliaire P3,P4, reliées à la borne d'alimentation batterie +Bat respectivement à la borne de masse du véhicule -Bat. Ainsi, on comprend que les self inductances précitées à noyau de ferrite permettent d'opposer la valeur de la troisième et de la quatrième impédance réactive Z3 et Z4 aux seuls signaux parasites engendrés par la commutation des balais du moteur respectivement par la fonction alimentée par les pistes d'alimentation auxiliaire P3,P4.

Un mode de mise en oeuvre préférentiel non limitatif des self inductances à noyau de ferrite constituant la troisième Z3 et la quatrième Z4 impédance réactive sera maintenant décrit en liaison avec les figures 3a ,3b et 3c.

En référence à la figure 3b, laquelle est une vue en coupe selon le plan de coupe PP de la figure 3a, on indique que les selfs inductances Z3 et Z4 à noyau de ferrite sont formées chacune par un premier élément de noyau de ferrite Z3a et Z4a, présentant un logement longitudinal central Z3alc et Z4alc respectivement, et par un deuxième élément de noyau de ferrite Z3b et Z4b , sensiblement identique au premier élément de noyau de ferrite. Sur la figure 3b, en raison de l'observation du plan de coupe PP, seuls sont représentés le premier et le deuxième élément de ferrite Z3a et Z3b et leur logement longitudinal central correspondant.

Selon un mode de mise en oeuvre préférentiel avantageux, le premier et le deuxième élément de noyau de ferrite Z3a, Z3b respectivement Z4a, Z4b constitutif des inductances Z3 et Z4 sont placés en vis-à-vis de façon à former, au niveau de leur logement longitudinal central mis en vis-à-vis, un manchon de passage entourant l'une au moins des pistes d'alimentation moteur P1, P2.

Sur la figure 3b, on comprend que le premier élément de noyau de ferrite Z3a est ainsi enfiché sur le deuxième élément de noyau de ferrite Z3b lequel repose sur la plaque de fermeture moteur PF, le montage par en fichage du premier élément de ferrite sur le deuxième étant représenté par la flèche F en trait mixte sur la figure 3b.

De préférence, ainsi que représenté en figure 3b, le premier et le deuxième élément de noyau de ferrite formant chaque inductance à noyau de ferrite sont maintenus chacun en vis-à-vis pour former le manchon entourant la piste conductrice considérée par un doigt à cliquet, noté d3a, d3b respectivement d4a, d4b, représentés sur la figure 3a. Les doigts à cliquet précités sont de préférence venus de matière de la plaque de fermeture PF, lors de la fabrication de cette dernière par moulage.

Une vue générale de l'ensemble ainsi constitué est représentée en figure 3c, selon la vue en coupe selon le plan de coupe de la figure 3a, lorsque le capot d'étanchéité moteur CE a été replacé sur l'ensemble ainsi constitué. On note, par exemple, qu'un doigt de maintien dm venu de matière du capot d'étanchéité moteur CE peut avantageusement être prévu afin de maintenir la cohésion mécanique de l'empilement des premiers et deuxième élément de noyau de ferrite constituant les selfs inductance Z3 et Z4.

Enfin, l'impédance à noyau de ferrite Z3,Z4 est formée ainsi que décrit en liaison avec les figures 3b et 3c.

L'impédance à noyau de ferrite peut être placée de façon à entourer au moins une piste d'alimentation principale moteur ou finalement toute piste d'alimentation auxiliaire de ce dernier.

Un exemple de mise en oeuvre du filtre objet de l'invention et d'au moins une impédance réactive sur les pistes d'alimentation auxiliaire de la commande « Arrêt fixe » d'un moteur d'essuie glace de véhicule automobile est donnée en liaison avec la figure 4.

Sur cette figure, on observe le filtre objet de l'invention, tel que représenté en figure 2, et l'impédance réactive formant la quatrième impédance réactive Z4 représentée en figure 3a.

Le filtre atténuateur/éliminateur de bande des inductions électromagnétiques pour moteur à courant continu à balais, selon l'invention, est aisément mis en oeuvre à partir de composants électroniques réactifs et capacitifs passifs normalement disponibles dans le commerce et n'implique aucune modification importante des dimensions et de l'encombrement du moteur. Ce dernier, muni d'un filtre selon l'invention, peut être prévu pour équiper des véhicules automobiles de tout type, en première ou deuxième monte.

## Revendications

1. Filtre atténuateur/éliminateur de bande des inductions électromagnétiques pour moteur à courant continu à balais, comportant au moins, intégrées à un filtre à inductances de compatibilité électromagnétique (EMC) formé par au moins une première impédance réactive (L1), insérée entre la borne d'alimentation positive moteur et la borne positive de la batterie (+Bat) et une deuxième impédance réactive (L2), insérée entre la borne d'alimentation négative moteur et la masse du véhicule (-Bat),
- une première impédance électrique capacitive (C1) connectée en parallèle entre la borne positive et la borne négative d'alimentation moteur ;
- une deuxième impédance électrique capacitive (C2, C3) de capacité électrique inférieure à celle de la première impédance capacitive (C1) et connectée en parallèle entre la borne positive de la batterie (+Bat) et la borne de masse du moteur (-Bat) ;
**caractérisé en ce qu'**il comprend en outre
- une troisième impédance réactive (Z3), ladite troisième impédance étant insérée en série entre la borne d'entrée de la première impédance réactive (L1) et la borne positive de la batterie (+Bat) et entre la borne de sortie de la deuxième impédance réactive (L2) et la borne de masse du véhicule (-Bat), la troisième impédance est une impédance réactive à noyau de ferrite pour filtrage des inductions électromagnétiques pour moteur à courant continu à balais formée par :
- un premier élément de noyau de ferrite (Z3a) présentant un logement longitudinal central (Z3alc) ; et,
- un deuxième élément de noyau de ferrite (Z3b) présentant un logement longitudinal central (Z3blc), identique à celui (Z3alc) du premier élément de noyau ferrite, le premier et le deuxième élément de noyau de ferrite (Z3a) (Z4a) étant placés en vis-à-vis de façon à former au niveau de leur logement longitudinal central en vis-à-vis un manchon de passage entourant l'une des pistes conductrices d'alimentation principale (P1,P2) du moteur.

2. Filtre atténuateur/éliminateur de bande des inductions électromagnétiques pour moteur à courant continu à balais selon la revendication 1, **caractérisé en ce que** ladite deuxième impédance capacitive (C2,C3) est constituée par des capacités électriques (C2), (C3) connectées en série, le point milieu des deux capacités électriques (C2,C3) étant connecté à la carcasse métallique du moteur (CM).

3. Filtre atténuateur/éliminateur de bande des inductions électromagnétiques pour moteur à courant continu à balais selon la revendication 2, **caractérisé en ce que** la première (C1), la deuxième (C2) et la troisième (C3) capacité électrique ont une même valeur, inférieure à 1µF.

4. Filtre atténuateur/éliminateur de bande des inductions électromagnétiques pour moteur à courant continu à balais selon l'une des revendications 1 à 3, **caractérisé en ce que** celui-ci comprend une quatrième impédance réactive (Z4) insérée en série sur un circuit d'alimentation auxiliaire du moteur.

5. Filtre atténuateur/éliminateur de bande des inductions électromagnétiques pour moteur à courant continu à balais selon la revendication 4, **caractérisé en ce que** la troisième (Z3) et la quatrième (Z4) impédance réactive ont une impédance de valeur identique.

6. Filtre atténuateur/éliminateur de bande des inductions électromagnétiques pour moteur à courant continu à balais selon la revendication 4 ou 5, **caractérisé en ce que** la quatrième impédance réactive (Z4) est constituée par une impédance réactive à noyau de ferrite pour filtrage des inductions électromagnétiques pour moteur à courant continu à balais formée par :
- un premier élément de noyau de ferrite (Z4a) présentant un logement longitudinal central (Z4alc) ; et,
- un deuxième élément de noyau de ferrite (Z4b) présentant un logement longitudinal central (Z4blc), identique à celui (Z4alc) du premier élément de noyau ferrite, le premier et le deuxième élément de noyau de ferrite (Z3b) (Z4b) étant placés en vis-à-vis de façon à former au niveau de leur logement longitudinal central en vis-à-vis un manchon de passage entourant l'une des pistes conductrices d'alimentation auxiliaire (P3,P4) du moteur.

7. Filtre atténuateur/éliminateur de bande des inductions électromagnétiques pour moteur à courant continu à balais selon l'une quelconque des revendications 1 à 6, **caractérisée en ce que** la troisième (Z3) et/ou la quatrième (Z4) impédance réactive ont une valeur supérieure à 50 ohms, dans une bande de fréquences comprises entre 100 M H z et 1GHz.

8. Moteur à courant continu à balais, **caractérisé en ce qu'**il comprend un filtre selon l'une quelconque des revendications 1 à 7.

9. Moteur selon la revendication 8, **caractérisé en ce qu'**il comprend une plaque de fermeture moteur (PF) et **en ce qu'**au moins l'une desdites impédances réactives à noyau de ferrite (Z3, Z4) est placée sur la plaque de fermeture (PF) du moteur, de préférence de façon à entourer une piste conductrice d'alimentation (P1,P2), (P3,P4) reliée à la borne d'alimentation batterie (+Bat) respectivement à la borne de masse (-Bat) du véhicule ou aux circuits d'alimentation auxiliaire du moteur.

10. Moteur selon la revendication 9, **caractérisé en ce qu'**au moins l'une desdites impédance réactive à noyau de ferrite (Z3,Z4) entourant une piste conductrice d'alimentation (P1,P2) et une desdites pistes conductrices d'alimentation (P1,P2) ou d'alimentation auxiliaire du moteur (P3, P4) sont placées sur la plaque de fermeture (PF) du moteur, le premier et le deuxième élément de noyau de ferrite (Z3a, Z3b) (Z4a, Z4b) formant chaque inductance à noyau de ferrite étant maintenus chacun en vis-à-vis par un doigt à cliquet (d3a) (d3b), de préférence venu de matière de la plaque de fermeture moteur (PF).

11. Moteur selon l'une quelconque des revendications 8 à 10, **caractérisé en ce qu'**il comprend un doigt de maintien (dm) assurant la cohésion mécanique de l'empilement des premiers et deuxième élément de noyau de ferrite constituant au moins l'une des impédances réactives à noyau de ferrite (Z3, Z4), ledit doigt étant de préférence venu de matière avec un capot d'étanchéité moteur (CE).

12. Moteur selon l'une quelconque des revendications 8 à 11, **caractérisé en ce que** les première et deuxième impédances réactives (L1, L2) et les première et deuxième impédances capacitives (C1, C2, C3) appartiennent à un circuit de prise de masse pour connexion de balai de moteur à courant continu.

13. Moteur selon la revendication 12, **caractérisé en ce qu'**il comporte une plaquette métallique (2) présentant deux zones de contact électrique (21, 22) destinées à être placée en contact électrique avec l'inducteur du moteur, et **en ce que** les deuxième et troisième impédances électriques capacitives (C2, C3) comportent chacune une première branche électriquement connectée à la plaquette métallique (2), et une deuxième branche électriquement connectée respectivement à la première impédance réactive (L1) connectée à un premier balai (B1) et à la deuxième impédance réactive (L2) connectée à un deuxième balai (B2).

## Patentansprüche

1. Banddämpfungs-/Eliminationsfilter für die elektromagnetischen Induktionen eines Gleichstrommotors mit Bürsten, umfassend mindestens, eingesetzt in einen Induktanzfilter von elektromagnetischer Kompatibilität (EMC), der von mindestens einer ersten reaktiven Impedanz (L1), die zwischen der positiven Motorversorgungsklemme und der positiven Klemme der Batterie (+Bat) eingesetzt ist, und einer zweiten reaktiven Impedanz (L2), die zwischen der negativen Motorversorgungsklemme und der Masse des Fahrzeugs (-Bat) eingesetzt ist, gebildet ist,
- eine erste kapazitive elektrische Impedanz (C1), die parallel zwischen der positiven und der negativen Motorversorgungsklemme angeschlossen ist;
- eine zweite kapazitive elektrische Impedanz (C2, C3) mit geringerer elektrische Kapazität als jene der ersten kapazitiven Impedanz (C1), die parallel zwischen der positiven Klemme der Batterie (+Bat) und der Massenklemme des Motors (-Bat) angeschlossen ist;
**dadurch gekennzeichnet, dass** er ferner umfasst
- eine dritte reaktive Impedanz (Z3), wobei die dritte Impedanz in Serie zwischen der Eingangsklemme der ersten reaktiven Impedanz (L1) und der positiven Klemme der Batterie (+Bat) und zwischen der Ausgangsklemme der zweiten reaktiven Impedanz (L2) und der Massenklemme des Fahrzeugs (-Bat) eingesetzt ist, wobei die dritte Impedanz eine reaktive Impedanz mit Ferritkern zum Filtern der elektromagnetischen Induktionen eines Gleichstrommotors mit Bürsten ist, gebildet von:
- einem ersten Ferritkernelement (Z3a), das eine zentrale Längsaufnahme (Z3alc) aufweist; und
- einem zweiten Ferritkernelement (Z3b), das eine zentrale Längsaufnahme (Z3blc) identisch mit jener (Z3alc) des ersten Ferritkernelements aufweist, wobei das erste und das zweite Ferritkernelement (Z3a) (Z4a) gegenüber angeordnet sind, um im Bereich ihrer gegenüberliegenden zentralen Längsaufnahmen einen Durchgangskanal zu bilden, der eine der leitenden Hauptversorgungsspuren (P1, P2) des Motors umgibt.

2. Banddämpfungs-/Eliminationsfilter für die elektromagnetischen Induktionen eines Gleichstrommotors mit Bürsten nach Anspruch 1, **dadurch gekennzeichnet, dass** die zweite kapazitive Impedanz (C2, C3) von elektrischen Kapazitäten (C2, C3) gebildet ist, die in Serie geschaltet sind, wobei der Mittelpunkt der zwei elektrischen Kapazitäten (C2, C3) an das Metallgehäuse des Motors (CM) angeschlossen ist.

3. Banddämpfungs-/Eliminationsfilter für die elektromagnetischen Induktionen eines Gleichstrommotors mit Bürsten nach Anspruch 2, **dadurch gekennzeichnet, dass** die erste (C1), die zweite (C2) und die dritte (C3) elektrische Kapazität einen selben Wert kleiner als 1µF haben.

4. Banddämpfungs-/Eliminationsfilter für die elektromagnetischen Induktionen eines Gleichstrommotors mit Bürsten nach einem der Ansprüche 1 bis 3, **dadurch gekennzeichnet, dass** dieser eine vierte reaktive Impedanz (Z4) umfasst, die in Serie auf einer Hilfsversorgungsschaltung des Motors eingesetzt ist.

5. Banddämpfungs-/Eliminationsfilter für die elektromagnetischen Induktionen eines Gleichstrommotors mit Bürsten nach Anspruch 4, **dadurch gekennzeichnet, dass** die dritte (Z3) und vierte (Z4) reaktive Impedanz eine Impedanz von identischem Wert haben.

6. Banddämpfungs-/Eliminationsfilter für die elektromagnetischen Induktionen eines Gleichstrommotors mit Bürsten nach Anspruch 4 oder 5, **dadurch gekennzeichnet, dass** die vierte reaktive Impedanz (Z4) von einer reaktiven Impedanz mit Ferritkern zum Filtern der elektromagnetischen Induktionen eines Gleichstrommotors mit Bürste gebildet ist, gebildet von:
- einem ersten Ferritkernelement (Z4a), das eine zentrale Längsaufnahme (Z4alc) aufweist; und
- einem zweiten Ferritkernelement (Z4b), das eine zentrale Längsaufnahme (Z4blc) identisch mit jener (Z4alc) des ersten Ferritkernelements aufweist, wobei das erste und das zweite Ferritkernelement (Z3b) (Z4b) gegenüber angeordnet sind, um im Bereich ihrer gegenüberliegenden zentralen Längsaufnahmen einen Durchgangskanal zu bilden, der eine der leitenden Hauptversorgungsspuren (P3, P4) des Motors umgibt.

7. Banddämpfungs-/Eliminationsfilter für die elektromagnetischen Induktionen eines Gleichstrommotors mit Bürsten nach einem der Ansprüche 1 bis 6, **dadurch gekennzeichnet, dass** die dritte (Z3) und/oder die vierte (Z4) reaktive Impedanz einen Wert größer als 50 Ohm in einem Frequenzband zwischen 100 MHz und 1 GHz haben.

8. Gleichstrommotor mit Bürste, **dadurch gekennzeichnet, dass** er einen Filter nach einem der Ansprüche 1 bis 7 umfasst.

9. Motor nach Anspruch 8, **dadurch gekennzeichnet, dass** er eine Motorverschlussplatte (PF) umfasst, und dass mindestens eine der reaktiven Impedanzen mit Ferritkern (Z3, Z4) auf der Verschlussplatte (PF) des Motors angeordnet ist, vorzugsweise derart, dass sie eine leitende Versorgungsspur (P1, P2), (P3, P4) umgibt, die mit der Batterieversorgungsklemme (+Bat) bzw. der Massenklemme (-Bat) des Fahrzeugs oder mit den Hilfsversorgungsschaltungen des Motors verbunden ist.

10. Motor nach Anspruch 9, **dadurch gekennzeichnet, dass** mindestens eine der reaktiven Impedanzen mit Ferritkern (Z3, Z4), die eine leitende Versorgungsspur (P1, P2) umgibt, und eine der leitenden Versorgungsspuren (P1, P2) oder Hilfsversorgungsspuren des Motors (P3, P4) auf der Verschlussplatte (PF) des Motors angeordnet sind, wobei das erste und das zweite Ferritkernelement (Z3a, Z3b) (Z4a, Z4b), die jede Induktanz mit Ferritkern bilden, jeweils durch einen Rastfinger (d3a) (d3b), der vorzugsweise mit der Motorverschlussplatte (PF) aus einem Stück ist, gegenüberliegend gehalten werden.

11. Motor nach einem der Ansprüche 8 bis 10, **dadurch gekennzeichnet, dass** er einen Haltefinger (dm) umfasst, der den mechanischen Zusammenhalt des Stapels der ersten und zweiten Ferritkernelemente, die mindestens eine der reaktiven Impedanzen mit Ferritkern (Z3, Z4) bilden, gewährleistet, wobei der Finger vorzugsweise mit einer Motorabdichtungskappe (CE) aus einem Stück ist.

12. Motor nach einem der Ansprüche 8 bis 11, **dadurch gekennzeichnet, dass** die ersten und zweiten reaktiven Impedanzen (L1, L2) und die ersten und zweiten kapazitiven Impedanzen (C1, C2, C3) einer Massenschaltung für den Bürstenanschluss des Gleichstrommotors angehören.

13. Motor nach Anspruch 12, **dadurch gekennzeichnet, dass** er eine Metallplakette (2) umfasst, die zwei elektrische Kontaktzonen (21, 22) aufweist, die dazu bestimmt sind, mit dem Induktor des Motors in elektrischem Kontakt angeordnet zu sein, und dass die zweiten und dritten kapazitiven elektrischen Impedanzen (C2, C3) jeweils einen ersten Schenkel, der elektrisch an die Metallplakette (2) angeschlossen ist, und einen zweiten Schenkel umfassen, der elektrisch an die erste reaktive Impedanz (L1), die mit einer ersten Bürste (B1) verbunden ist, bzw. an die zweite reaktive Impedanz (L2), die mit einer zweiten Bürste (B2) verbunden ist, angeschlossen ist.

## Claims

1. A band attenuation/elimination filter for the electromagnetic emissions of a DC motor with brushes, comprising at least, incorporated in a filter with electromagnetic compatibility (EMC) inductances formed by at least one first reactive impedance (L1), inserted between the positive motor power supply terminal and the positive terminal of the battery (+Bat) and a second reactive impedance (L2), inserted between the negative motor power supply terminal and the ground of the vehicle (-Bat),
- a first capacitive electrical impedance (C1) connected in parallel between the positive and negative motor power supply terminals;
- a second capacitive electrical impedance (C2, C3) of electrical capacitance less than that of the first capacitive impedance (C1) and connected in parallel between the positive terminal of the battery (+Bat) and the ground terminal of the motor (-Bat);
**characterized in that** it additionally comprises
- a third reactive impedance (Z3), said third impedance being inserted in series between the input terminal of the first reactive impedance (L1) and the positive terminal of the battery (+Bat) and between the output terminal of the second reactive impedance (L2) and the ground terminal of the vehicle (-Bat), the third impedance is a reactive impedance with ferrite core for filtering the electromagnetic emissions of a DC motor with brushes formed by:
- a first ferrite core element (Z3a) having a central longitudinal housing (Z3alc); and
- a second ferrite core element (Z3b) having a central longitudinal housing (Z3blc), identical to that (Z3alc) of the first ferrite core element, the first and the second ferrite core elements (Z3a) (Z4a) being placed facing one another so as to form, at the level of their facing central longitudinal housings, a bushing surrounding one of the main conductive power supply tracks (P1, P2) of the motor.

2. The band attenuation/elimination filter for the electromagnetic emissions of a DC motor with brushes as claimed in claim 1, **characterized in that** said second capacitive impedance (C2, C3) is made up of electrical capacitors (C2), (C3) connected in series, the midpoint of the two electrical capacitors (C2, C3) being connected to the metal frame of the motor (CM).

3. The band attenuation/elimination filter for the electromagnetic emissions of a DC motor with brushes as claimed in claim 2, **characterized in that** the first (C1), the second (C2) and the third (C3) electrical capacitors have the same value, less than 1 µF.

4. The band attenuation/elimination filter for the electromagnetic emissions of a DC motor with brushes as claimed in one of claims 1 to 3, **characterized in that** the latter comprises a fourth reactive impedance (Z4) inserted in series on an auxiliary power supply circuit of the motor.

5. The band attenuation/elimination filter for the electromagnetic emissions of a DC motor with brushes as claimed in claim 4, **characterized in that** the third (Z3) and the fourth (Z4) reactive impedances have an impedance of identical value.

6. The band attenuation/elimination filter for the electromagnetic emissions of a DC motor with brushes as claimed in claim 4 or 5, **characterized in that** the fourth reactive impedance (Z4) consists of a reactive impedance with ferrite core for filtering the electromagnetic emissions of a DC motor with brushes formed by:
- a first ferrite core element (Z4a) having a central longitudinal housing (Z4alc); and
- a second ferrite core element (Z4b) having a central longitudinal housing (Z4blc), identical to that (Z4alc) of the first ferrite core element, the first and the second ferrite core elements (Z3b) (Z4b) being placed facing one another so as to form, at the level of their facing central longitudinal housings, a bushing surrounding one of the auxiliary conductive power supply tracks (P3, P4) of the motor.

7. The band attenuation/elimination filter for the electromagnetic emissions of a DC motor with brushes as claimed in one of claims 1 to 6, **characterized in that** the third (Z3) and/or the fourth (Z4) reactive impedance have a value greater than 50 ohms in a frequency band between 100 MHz and 1 GHz

8. A DC motor with brushes, **characterized in that** it comprises a filter as claimed in any one of claims 1 to 7.

9. The motor as claimed in claim 8, **characterized in that** it comprises a motor closure plate (PF) and **in that** at least one of said reactive impedances with ferrite core (Z3, Z4) is placed on the motor closure plate (PF), preferably so as to surround a conductive power supply track (P1, P2), (P3, P4) linked to the battery power supply terminal (+Bat) or to the ground terminal (-Bat) of the vehicle or to the auxiliary power supply circuits of the motor.

10. The motor as claimed in claim 9, **characterized in that** at least one of said reactive impedances with ferrite core (Z3, Z4) surrounding a conductive power supply track (P1, P2) and one of said conductive power supply (P1, P2) or auxiliary power supply tracks of the motor (P3, P4) are placed on the motor closure plate (PF), the first and the second ferrite core elements (Z3a, Z3b) (Z4a, Z4b) forming each inductance with ferrite core being each held facing one another by a pawl (d3a) (d3b), preferably made of the same material as the motor closure plate (PF).

11. The motor as claimed in any one of claims 8 to 10, **characterized in that** it comprises a securing finger (dm) ensuring the mechanical cohesion of the stack of the first and second ferrite core elements forming at least one of the reactive impedances with ferrite core (Z3, Z4), said finger preferably being made of the same material as a motor sealing cover (CE).

12. The motor as claimed in any one of claims 8 to 11, **characterized in that** the first and second reactive impedances (L1, L2) and the first and second capacitive impedances (C1, C2, C3) belong to a grounding circuit for DC motor brush connection.

13. The motor as claimed in claim 12, **characterized in that** it comprises a metal plate (2) having two electrical contact areas (21, 22) intended to be placed in electrical contact with the inductor of the motor, and **in that** each of the second and third capacitive electrical impedances (C2, C3) comprise a first branch electrically connected to the metal plate (2), and a second branch electrically connected respectively to the first reactive impedance (L1) connected to a first brush (B1) and to the second reactive impedance (L2) connected to a second brush (B2).
